# EUROPÄISCHE PATENTSCHRIFT

(11) **EP 2 100 369 B1**
(45) Veröffentlichungstag und Bekanntmachung des Hinweises auf die Patenterteilung: **01.09.2010**
(21) Anmeldenummer: 07821377.4
(22) Anmeldetag: 16.10.2007
(51) Int. Cl.: H02P 6/18

(54) **DETEKTORSCHALTUNG**
DETECTOR CIRCUIT
CIRCUIT DE DÉTECTION

(30) Priorität: 01.12.2006 DE 102006056852
(43) Veröffentlichungstag der Anmeldung: 16.09.2009
(73) Patentinhaber: Robert Bosch GmbH, 70442 Stuttgart (DE)
(72) Erfinder: KRAUTH, Wolfgang, 77855 Achern-Sasbachried (DE); KNECHT, Gerhard, 76473 Iffezheim (DE)
(86) Internationale Anmeldenummer: PCT/EP2007/061011
(87) Internationale Veröffentlichungsnummer: WO 2008/064951

(56) Entgegenhaltungen:
- JP-A- 11 046 492
- JP-A- 62 203 588
- JP-A- 63 190 588

## Beschreibung

Die Erfindung betrifft eine Detektorschaltung, insbesondere zum Detektieren einer Spannungsänderung an einer Spulenwicklung einer Antriebsspule eines Elektromotors.

Bei EC-Motoren mit sensorloser Kommutierung wird die Rotorposition dadurch erfasst, dass man die Spannung an einzelnen Spulenwicklungen überwacht und anhand einer Spannungsänderung an einer nicht angesteuerten Spulenwicklung den Zeitpunkt feststellt, zu dem ein an der Spulenwicklung sich vorbei bewegender Magnetpol eine Spannung induziert.

Üblicherweise ist ein erster Anschluss einer Spulenwicklung fest mit einem ersten Versorgungsspannungspotenzial verbunden, wie es beispielsweise bei einer M-Schaltung von Spulenwicklungen eines Elektromotors der Fall ist. Ein zweiter Anschluss der Spulenwicklung ist über einen ansteuerbaren Transistor mit einem zweiten Versorgungsspannungspotenzial verbunden. Im nicht angesteuerten Zustand ist der zweite Anschluss nur über die Spulenwicklung mit dem Versorgungsspannungspotenzial verbunden. Sobald sich die Spulenwicklung jedoch über einen Magnetpol bewegt, wird eine Spannung induziert, die zu einer Spannungsänderung bezüglich des Versorgungsspannungspotenzials führt. Die Spannungsänderung wird detektiert und ein Detektorsignal generiert, das zur Bestimmung der Rotorlage verwendet wird. Abhängig von der bestimmten Rotorlage wird die Kommutierung des Elektromotors durchgeführt.

Aus der JP 63 190 588 ist eine Detektionsschaltung für einen bürstenlosen Elektromotor bekannt, die ausgelegt ist, um die in Spulenwicklungen des Elektromotors induzierte Spannung zu detektieren. Dazu wird die induzierte Spannung jeder der Spulenwicklungen abgegriffen und über eine Serienschaltung eines Widerstands und einer jeweiligen Diode an einen Eingang eines Differenzverstärkers angelegt. Weiterhin wird der Eingang des Differenzverstärkers ebenso mit einer Reihenschaltung eines Transistors und eines Widerstands, zwischen denen ein Detektionssignal abgreifbar ist, verbunden, wobei der Ausgang des Differenzverstärkers mit einem Steuereingang des Transistors verbunden ist.

Üblicherweise wird zur Detektion der Spannungsänderung über einer Spulenwicklung das Potenzial an dem zweiten Anschluss der Spulenwicklung durch einen Spannungsteiler reduziert und mit einer z.B. über einen weiteren Spannungsteiler aus der Versorgungsspannung generierten Schwellspannung z.B. mit Hilfe eines Differenzverstärkers, Komparators und dergleichen verglichen, um den Zeitpunkt der zu detektierenden Spannungsänderung an der Motorwicklung zu detektieren.

Die Verwendung von Spannungsteilern ist notwendig, da im dargestellten Beispiel die Spannungsänderung im Bereich des Versorgungsspannungspotenzials erfolgt, der üblicherweise außerhalb des Gleichtaktunterdrückungsbereiches des Differenzverstärkers liegt. Bei Verwendung von Spannungsteilern haben die Toleranzen der für die Spannungsteiler verwendeten Widerstände jedoch einen erheblichen Einfluss auf die generierte Vergleichsspannung, insbesondere wenn das Teilungsverhältnis groß ist. Dadurch verschlechtert sich die Genauigkeit der Bestimmung des Zeitpunktes des Nulldurchgangs bzw. des Polwechsels des Elektromotors, wodurch der Wirkungsgrad der Kommutierung beeinträchtigt wird.

Es ist Aufgabe der vorliegenden Erfindung, die Empfindlichkeit der Detektorschaltung hinsichtlich Bauelementtoleranzen zu reduzieren, so dass der Zeitpunkt der Spannungsänderung genauer erfasst werden kann und so dass bei Verwendung der Detektorschaltung in einem Motorsteuersystem der Wirkungsgrad der Ansteuerung eines Elektromotors mit sensorloser Kommutierung erhöht werden kann.

Diese Aufgaben werden durch die Detektorschaltung gemäß Anspruch 1 sowie durch das Motorsteuersystem und das Elektromotorsystem gemäß der nebengeordneten Ansprüche gelöst.

Gemäß einem ersten Aspekt ist eine Detektorschaltung zum Detektieren einer Spannungsänderung an einem Anschluss bezüglich eines Referenzpotenzials vorgesehen. Die Detektorschaltung umfasst einen elektronischen Schalter mit einem Steueranschluss, der ein vorbestimmtes Schaltpotential aufweist, an dem der Schalter schaltet, und mit einem Detektionssignalausgang zum Ausgeben eines Detektionssignals. Weiterhin ist eine Spannungsanpassungsschaltung vorgesehen, die ein Steuerpotenzial an dem Steueranschluss des Schalters bereitstellt, das einem um einen vorgegebenen festen Potenzialbetrag veränderten Potenzial des Anschlusses entspricht. Der vorgegebene feste Potenzialbetrag ist so gewählt, dass das Steuerpotenzial bei Anliegen der Referenzspannung an dem Anschluss so dem Schaltpotenzial bzw. ungefähr dem Schaltpotenzial entspricht, so dass die zu detektierende Spannungsänderung ein Über- bzw. Unterschreiten des Schaltpotenzials des elektronischen Schalters bewirkt.

Die Detektorschaltung ermöglicht es, eine Spannungsänderung an einem Anschluss, dessen Potenzial auch außerhalb der Versorgungsspannung der Detektorschaltung liegen kann, zu detektieren und als eine Flanke des Detektionssignals auszugeben. Weiterhin ist durch die Verwendung der Spannungsanpasssungsschaltung, die die zu detektierende Spannung um einen festen (im Wesentlichen absoluten) Potenzialbetrag auf die Schaltschwelle des elektronischen Schalters verändert, der Einfluss von Widerstandstoleranzen reduziert. Weiterhin ist die Spannungsanpassungsschaltung in vorteilhafter Weise mit einer Diode ausgebildet, die mit dem Anschluss und mit dem Steueranschluss des elektronischen Schalters unmittelbar verbunden ist, wobei der vorgegebene Spannungsbetrag der Diodenspannung bzw. der Durchbruchsspannung der Diode entspricht, die über die Diode abfällt.

Weitere vorteilhafte Ausgestaltungen der Erfindung sind in den abhängigen Ansprüchen angegeben.

Gemäß einer weiteren Ausführungsform ist der elektronische Schalter als eine Transistorschaltung mit einem ersten Transistor ausgebildet, dessen Basisanschluss dem Steueranschluss entspricht und dessen Basis-Emitter-Spannung bei Anliegen der Referenzspannung an dem Anschluss im Wesentlichen auf die Diodenspannung eines Basis-Emitter-Übergangs des ersten Transistors eingestellt ist, so dass der erste Transistor gerade noch leitend ist, wobei die Spannungsanpassungsschaltung so ausgebildet ist, dass die Basis-Emitter-Spannung bei Auftreten der zu detektierenden Spannungsänderung unter die Diodenspannung sinkt, so dass der erste Transistor in den sperrenden Zustand übergeht.

Weiterhin kann die Referenzspannung einem Versorgungsspannungspotenzial entsprechen und der Emitteranschluss des ersten Transistors direkt mit dem Versorgungsspannungspotenzial verbunden sein, so dass das Schaltpotenzial als das um die Diodenspannung des Basis-Emitter-Übergangs geänderte Versorgungsspannungspotential festgelegt ist.

Es kann vorgesehen sein, dass die Spannungsanpassungsschaltung einen zweiten Transistor umfasst, dessen Kollektoranschluss und Basisanschluss kurzgeschlossen sind und mit dem Steueranschluss des Schalters verbunden sind, so dass sich zwischen Emitteranschluss und Kollektoranschluss des zweiten Transistors eine Diodenspannung des Basis-Emitter-Übergangs des zweiten Transistors einstellt.

Vorzugsweise sind der erste und der zweite Transistor als identische Transistoren ausgebildet, wobei der Emitteranschluss des zweiten Transistors über einen Abgriffwiderstand mit dem Anschluss und der Kollektoranschluss des zweiten Transistors über einen weiteren Widerstand mit einem weiteren Versorgungsspannungspotential verbunden sind, wobei das Widerstandsverhältnis zwischen dem Abgriffwiderstand und dem weiteren Widerstand maximal 1:50 beträgt.

Insbesondere sind der erste und der zweite Transistor als Doppeltransistoren in integrierter Form ausgebildet.

Gemäß einem weiteren Aspekt ist eine Motorsteuerung zum Ansteuern eines Elektromotors mit einem Ansteuersignal vorgesehen. Die Motorsteuerung umfasst eine Detektorschaltung zum Ausgeben eines Detektionssignals, das eine induktive Spannungsänderung einer Spulenwicklung des Elektromotors angibt, und eine Kommutatorschaltung zum Kommutieren der Spulenwicklung des Elektromotors abhängig von dem Detektionssignal.

Gemäß einem weiteren Aspekt ist ein Elekromotorsystem vorgehen mit einer Motorsteuerung und mit einem Elektromotor mit mindestens einer Spulenwicklung vorgehen, wobei die Spulenwicklung mit einem ersten Anschluss fest mit einem Versorgungsspannungspotential verbunden ist, und wobei der Anschluss der Detektorschaltung mit dem zweiten Anschluss der Spulenwicklung verbunden ist, um beim Betrieb des Motors eine in der Spulenwicklung induzierte Spannung zu detektieren.

Eine bevorzugte Ausführungsform der Erfindung wird nachfolgend anhand der beigefügten Zeichnungen näher erläutert. Es zeigen:
Fig. 1 ein Schaltbild einer Motorsteuerschaltung mit einer Detektorschaltung gemäß einer ersten Ausführungsform der Erfindung; und
Fig. 2 ein Schaltbild einer Motorsteuerschaltung mit einer Detektorschaltung gemäß einer weiteren Ausführungsform der Erfindung.

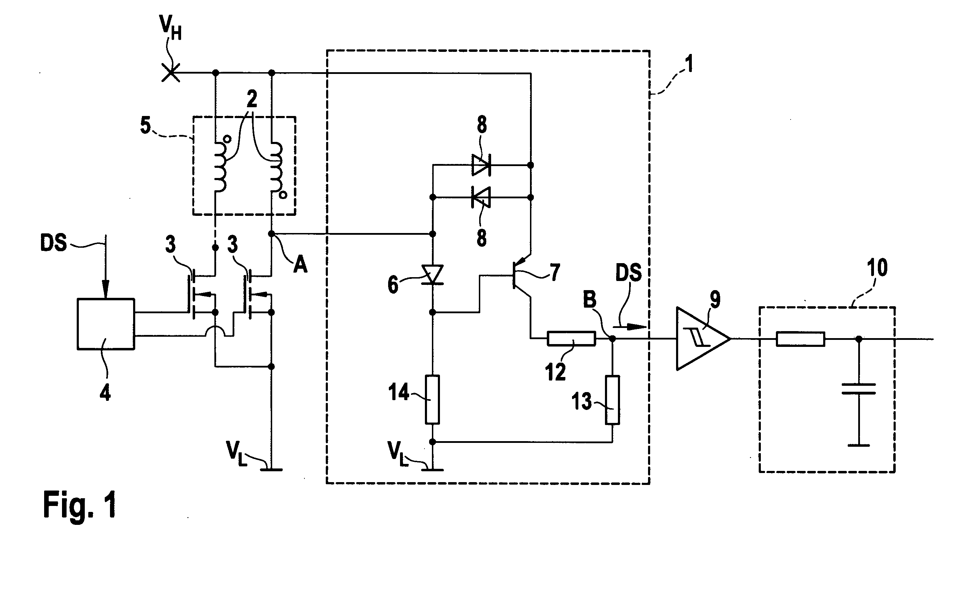

Figur 1 zeigt ein Schaltbild einer Motorsteuerschaltung mit einer Detektorschaltung 1 gemäß einer ersten Ausführungsform der Erfindung. Die Detektorschaltung 1 ist an eine Spulenwicklung 2 einer Antriebsspule 5 eines Elektromotors (nicht gezeigt) angeschlossen, um ein Potenzial abzugreifen. Der Übersichtlichkeit halber ist nur eine Antriebsspule des Elektromotors dargestellt, die bifilar mit zwei entgegengesetzt gewickelten Spulenwicklungen ausgebildet ist. Jede Spulenwicklung 2 wird über einen geeigneten Schalttransistor 3 betrieben, der mit der Spulenwicklung 2 in Reihe geschaltet ist und durch eine Kommutatorschaltung 4 zum Betreiben des Motors mit einem jeweiligen Ansteuersignal angesteuert wird, z.B. mit Hilfe von pulsweitenmodulierten Ansteuersignalen. Die Kommutation, d.h. das Einschalten und Ausschalten der Spulenwicklungen 2 der Antriebsspule des Elektromotors erfolgt abhängig von der Rotorlage, Drehzahl des Elektromotors und anderen Parametern.

Bei sensorlosen Elektromotoren erfolgt die Feststellung der Rotorlage durch Detektieren einer Spannungsänderung in mindestens einer der Spulenwicklungen, die aufgrund einer Relativbewegung zwischen der Spulenwicklung und einem Magnetpol durch Induktion hervorgerufen wird. Bei der zuvor dargestellten Motortopologie sind gemäß einer M-Schaltung alle Spulenwicklungen 2 mit ihren ersten Anschlüssen mit einem hohen Versorgungspotenzial V_{H} verbunden. Eine induzierte Spannung kann dann als Potenzialänderung an einem zweiten Anschluss der Spulenwicklung 2 detektiert werden, wenn die betreffende Spulenwicklung 2 nicht durch die Kommutatorschaltung 4 über den entsprechenden Schalttransistor angesteuert ist. Der Ausdruck "Potenzial" wird hierin als Spannungspotenzial an einem Knoten verstanden, während als "Spannung" der Potenzialunterschied zwischen zwei Knoten bezeichnet wird.

Kern der Detektorschaltung 1 stellt eine Transistorschaltung dar mit einem Transistor 7 und mit den Kollektorwiderständen 12 und 13, die in Form einer Emitterschaltung verschaltet sind. Im Detail heißt das, dass der Emitter des Transistors 7, der als pnp-Transistor ausgebildet ist, mit dem hohen Versorgungsspannungspotenzial V_{H} und der Kollektor des Transistors 7 über eine Reihenschaltung der Kollektorwiderstände 12 und 13 mit einem niedrigen Versorgungsspannungspotenzial V_{L} verbunden ist.

Die Emitterschaltung wird als elektronischer Schalter betrieben, der über den Basisanschluss des Transistor 7 gesteuert wird. An den Basisanschluss des Transistors 7 wird in einem Nicht-Induktions-Fall, bei dem keine Spannung in die Spulenwicklung 2 induziert wird, ein Steuerpotenzial angelegt, das den Transistor 7 an oder gerade über der Schaltschwelle betreibt. D.h., im Nicht-Induktions-Fall ist der Transistor 7 gerade leitend bzw. niederohmig bzw. deutlich niederohmiger als im gesperrten Zustand.

Das Steuerpotenzial wird aus dem Potenzial an einem Knoten A, der dem zweiten Anschluss der Spulenwicklung 2 entspricht, und einer Diode 6 erzeugt. Die Diode 6 ist in Reihe mit einem weiteren Widerstand 14 zwischen dem Knoten A und dem niedrigen Versorgungsspannungspotenzial V_{L} geschaltet. Der weitere Widerstand 14 ermöglicht es, dass sich über der Diode 6 ein Spannungsabfall in Höhe der Diodenspannung ausbildet. An der Kathode der Diode 6, d.h. an dem Knoten zwischen der Diode 6 und dem weiteren Widerstand 14, wird das Steuerpotenzial abgegriffen. Die Diode 6 ist so dimensioniert, dass sich als Steuerpotenzial ein Potenzial einstellt, bei dem der Transistor 7 gerade noch durchgeschaltet, d.h. leitend ist. Wird nun eine Spannung in die Spulenwicklung 2 induziert, die bewirkt, dass das Potenzial an dem Knoten A ansteigt, so steigt auch das Steuerpotenzial an dem Basisanschluss des Transistors 7 an, da das Steuerpotenzial im Wesentlichen das um die Diodenspannung der Diode 6 verminderte Potenzial des zweiten Anschlusses der Spulenwicklung 2 darstellt. Bereits eine minimale Erhöhung des Steuerpotenzials an dem Steuerpotenzial des Transistors 7 hat jedoch zur Folge, dass der Transistor 7 von einem niederohmigeren Zustand in einen sperrenden Zustand übergeht. Anstelle der herkömmlichen Diode 6 kann auch eine Zener-Diode im Sperrbetrieb vorgesehen sein, um das Potenzial an dem Anschluss A um die Durchbruchsspannung zu vermindern, so dass eine möglichst genaue Anpassung des Steuerpotenzials an die Schaltschwelle vorgenommen werden kann.

Wie oben bereits beschrieben, ist der Kollektoranschluss des Transistors 7 über eine Serienschaltung von zwei Kollektorwiderständen 12 und 13 mit dem niedrigen Versorgungsspannungspotenzial V_{L} verbunden. An einem Knoten B zwischen den beiden Kollektorwiderständen 12, 13 kann als Ausgang der Detektorschaltung ein Detektionssignal DS abgegriffen werden, das wie zuvor beschrieben das Auftreten einer Spannungserhöhung in der Spulenwicklung 2 aufgrund einer Induktion detektiert, indem im Induktionsfall ein Spannungsabfall detektierbar ist. Bei einem Spannungsanstieg an dem Knoten A ergibt sich als Detektionssignal DS eine fallende Flanke an dem Knoten B.

Das Detektionssignal DS kann nun an einen Eingang eines Schmitt-Triggers 9 oder alternativ eines Komparators und dergleichen angeschlossen werden, um die Flankensteilheit noch weiter zu erhöhen und um Störsignaleinflüsse z.B. durch Übersprechen des Ansteuersignals auf das Detektionssignal DS zu reduzieren. Weiterhin kann ein Ausgang des Schmitt-Triggers 9 mit einer Filterschaltung 10 verbunden werden, um Störeinflüsse durch die Taktung der Strangspannungen durch die Kommutatorschaltung 4 zu eliminieren. Der Filter 10 ist als ein Tiefpassfilter ausgebildet, da die Frequenz der Spannungsinduktionen in die Spulenwicklungen deutlich geringer ist als die Frequenz der Ansteuerung der Strangspannungen durch die Kommutatorschaltung 4.

Das Vorsehen der Kollektorwiderstände 12 und 13 ermöglicht es, die Ausgangsspannung der Emitterschaltung in einen Potenzialbereich zu bringen, in dem der Schmitt-Trigger 9 empfindlich ist. In einer beispielhaften Ausführungsform kann die Versorgungsspannung des Elektromotors (V_{H} - V_{L}) 12 Volt betragen und als Schmitt-Trigger 9 ein Standardbaustein verwendet werden, der eine Versorgungsspannung von z.B. 5 Volt benötigt. Somit ist der Schmitt-Trigger 9 nur in einem Spannungsbereich zwischen 0 und 5 Volt (z.B. bei ca. 2,5V) empfindlich, so dass mithilfe der Kollektorwiderstände 12 und 13 die Ausgangsspannung der Emitterschaltung in einen Arbeitsbereich des Schmitt-Triggers 9 gebracht werden kann.

Wenn z.B. die Versorgungsspannung des Elektromotors und der gesamten Spannungsdetektorschaltung einer Versorgungsspannung des Schmitt-Triggers 9 entspricht, kann beispielsweise anstelle der Kollektorwiderstände 12 und 13 nur ein einzelner Kollektorwiderstand zwischen dem Kollektoranschluss des Transistors 7 und dem niedrigen Versorgungsspannungspotenzial V_{L} verwendet werden, wobei der Ausgang der Emitterschaltung in diesem Fall direkt an dem Kollektor des Transistors 7 abgreifbar ist.

Optional können zum Schutz der Detektorschaltung 1 können zwei parallel, zueinander entgegengesetzt geschaltete Freilaufdioden 8 vorgesehen sein, die zwischen dem zweiten Anschluss der Spulenwicklung 2 und dem hohen Versorgungsspannungspotenzial V_{H} vorgesehen sind, so dass darüber eine induzierte Spannung in der Spulenwicklung 2, deren Betrag größer ist als die Diodenspannung, durch die jeweilige Freilaufdiode 8 sowohl in positiver als auch in negativer Richtung gegenüber dem hohen Versorgungsspannungspotenzial V_{H} begrenzt werden kann.

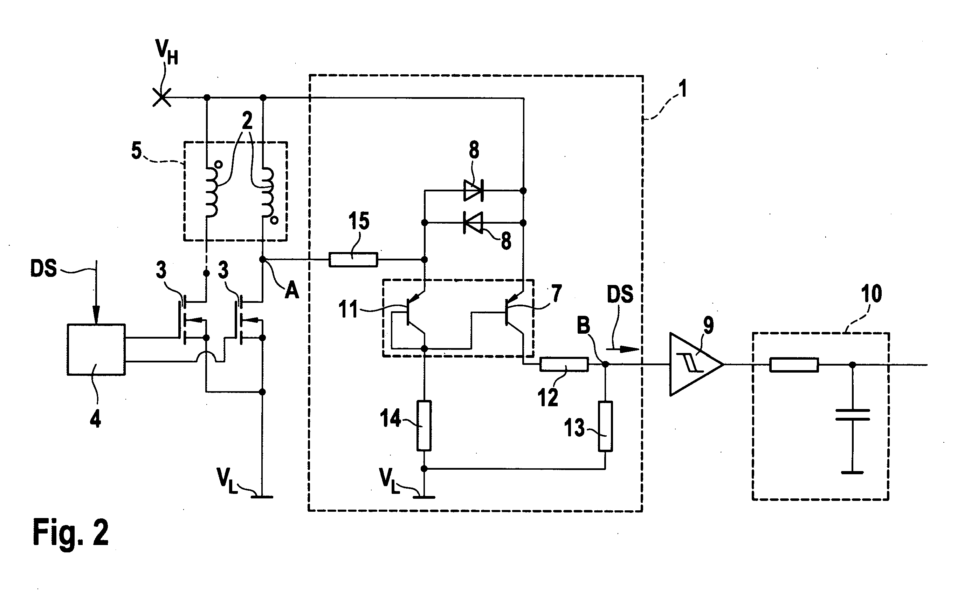

In Fig. 2 ist eine weitere Ausführungsform der Erfindung dargestellt. Darin entsprechen gleiche Bezugszeichen Elementen gleicher oder vergleichbarer Funktion.

Da es in der Praxis schwierig ist, z.B. bei Verwendung von diskreten Bauelementen, die Diode 6 so auszuwählen, dass der Transistor 7 nahe seiner Schaltschwelle oder unmittelbar auf seiner Schaltschwelle betrieben wird, kann anstelle der Diode 6 ein zu dem Transistor 7 identischer weiterer Transistor 11 vorgesehen werden. In einem solchen Fall wird der identische weitere Transistor 11 als Diode geschaltet, d.h. sein Basisanschluss ist direkt, vorzugsweise unmittelbar, mit seinem Kollektoranschluss verbunden. Die Diodenspannung des als Diode geschalteten weiteren Transistors 11 und die Spannung der Schaltschwelle des Transistors 7 sind somit nahezu identisch.

Um den Transistor 7 im Nicht-Induktions-Fall im leitenden bzw. im niederohmigen Zustand zu betreiben, sind ein Abgriffwiderstand 15 und der weitere Widerstand 14 vorgesehen. Der Abgriffwiderstand 15 ist, vorzugsweise unmittelbar, zwischen dem Knoten A, d.h. dem zweiten Anschluss der Spulenwicklung 2, und dem Emitteranschluss des weiteren Transistors 11 und der weitere Widerstand 14 zwischen dem Kollektoranschluss des weiteren Transistors 11 und dem niedrigen Versorgungsspannungspotenzials V_{L} angeordnet. Ein Stromfluss von dem Knoten A über den Abgriffwiderstand 15, den weiteren Transistor 11 und den weiteren Widerstand 14 zu dem niedrigen Versorgungsspannungspotenzial V_{L} bewirkt einen Spannungsabfall über dem Abgriffwiderstand 15, so dass das Steuerpotenzial, das an dem Basisanschluss des Transistors 7 anliegt, so weit erniedrigt wird, dass sich der Transistor 7 im eingeschalteten Zustand befindet. Um die Empfindlichkeit der Spannungsdetektorschaltung 1 nicht dadurch zu beeinträchtigen, dass das Steuerpotenzial im Nicht-Induktions-Fall zu weit von dem eigentlichen Schaltpotenzial des Transistors 7 entfernt wird, ist das Verhältnis des Abgriffwiderstandes 15 zu dem weiteren Widerstand 14 vorzugsweise sehr klein, d.h. 1:50 und kleiner, insbesondere 1:100. Bevorzugte Werte sind z.B. für den Abgriffwiderstand 15 im Bereich von 1 kOhm zu 10 kOhm und für den weiteren Widerstand R2 im Bereich von 100kOhm bis 500kOhm.

Der Spannungsteiler aus den Kollektorwiderständen 12 und 13 passt den niedrigen Messbereich eines nachgeschalteten Komparators bzw. Schmitt-Triggers 9 an. Vorzugsweise ist jedoch der Gesamtwiderstand der Kollektorwiderstände 12, 13 groß gewählt, da dadurch die Verstärkung der mit dem Transistor 7 gebildeten Emitterschaltung erhöht wird.

Um zu gewährleisten, dass die Diodenspannungen des Basis-Emitter-Übergangs der Transistoren 7 und 11 möglichst identisch sind, werden die Transistoren für die Detektorschaltung 1 vorzugsweise als ein Doppeltransistor ausgeführt, wobei die beiden Transistoren 7, 11 gemeinsam integriert ausgebildet sind, so dass diese im Wesentlichen baugleich sind und sich thermische Effekte durch die Integration weitgehend kompensieren.

Bei der Ausführungsform sind die Freilaufdioden 8 zwischen dem Emitteranschluss des weiteren Transistors 11 und dem hohen Versorgungsspannungspotenzial V_{H} angeschlossen.

Die Detektorschaltung kann auch in analoger Weise zur Detektion einer Spannungsverminderung bezüglich eines niedrigen Versorgungsspannungspotenzials ausgebildet werden, indem diese invers mit einer npn-Transistorschaltung und durch Vertauschen des hohen und niedrigen Versorgungsspannungspotenzials ausgebildet wird. Als Spannungsanpassungselement zum Anpassen des Potenzials am Anschluss A kann auch eine Gleichspannungsquelle, z.B. in Form einer Batterie und dergleichen, verwendet werden.

Die Detektorschaltung 1 erzeugt ein Detektionssignal DS, das, optional gefiltert durch den Schmitt-Trigger 9 und den Tiefpassfilter 10, der Kommutatorschaltung 4 zugeführt wird, die das Detektionssignal auswertet und daraus die Rotorlage, die Drehzahl des Motors und andere relevante Größen bestimmen kann.

## Patentansprüche

1. Detektorschaltung (1) zum Detektieren einer Spannungsänderung an einem Anschluss (A) bezüglich eines Referenzpotenzials, umfassend:
- einen elektronischen Schalter (7) mit einem Steueranschluss, der ein vorbestimmtes Schaltpotential aufweist, an dem der Schalter schaltet, und mit einem Detektionssignalausgang zum Ausgeben eines Detektionssignals (DS),
- eine Spannungsanpassungsschaltung, die ein Steuerpotenzial an dem Steueranschluss des Schalters bereitstellt, das einem um einen vorgegebenen festen Potenzialbetrag veränderten Potenzial des Anschlusses (A) entspricht, wobei der vorgegebene feste Potenzialbetrag so gewählt ist, dass das Steuerpotenzial bei Anliegen der Referenzspannung an dem Anschluss (A) so dem Schaltpotenzial bzw. ungefähr dem Schaltpotenzial entspricht, so dass die zu detektierende Spannungsänderung ein Über- bzw. Unterschreiten des Schaltpotenzials des elektronischen Schalters bewirkt,
**dadurch gekennzeichnet dass,** die Spannungsanpassungsschaltung mit einer Diode (6) ausgebildet ist, die mit dem Anschluss (A) und mit dem Steueranschluss des elektronischen Schalter (7) unmittelbar verbunden ist, wobei der vorgegebene Potenzialbetrag der Diodenspannung bzw. der Durchbruchsspannung der Diode (6) entspricht, die über die Diode (6) abfällt.

2. Detektorschaltung (1) nach Anspruch 1, wobei der elektronische Schalter als eine Transistorschaltung mit einem ersten Transistor (7) ausgebildet ist, dessen Basisanschluss dem Steueranschluss entspricht und dessen Basis-Emitter-Spannung bei Anliegen der Referenzspannung an dem Anschluss im Wesentlichen auf die Diodenspannung eines Basis-Emitter-Übergangs des ersten Transistors (7) eingestellt ist, so dass der erste Transistor (7) gerade noch leitend ist, wobei die Spannungsanpassungsschaltung so ausgebildet ist, dass die Basis-Emitter-Spannung bei Auftreten der zu detektierenden Spannungsänderung unter die Diodenspannung sinkt, so dass der erste Transistor (7) in den sperrenden Zustand übergeht.

3. Detektorschaltung (1) nach Anspruch 1, wobei die Referenzspannung einem Versorgungsspannungspotenzial entspricht und der Emitteranschluss des ersten Transistors (7) direkt mit dem Versorgungsspannungspotenzial verbunden ist, so dass das Schaltpotenzial als das um die Diodenspannung des Basis-Emitter-Übergangs geänderte Versorgungsspannungspotential festgelegt ist.

4. Detektorschaltung (1) nach einem der Ansprüche 2 und 3, wobei die Spannungsanpassungsschaltung einen zweiten Transistor (11) umfasst, dessen Kollektoranschluss und Basisanschluss kurzgeschlossen sind und mit dem Basisanschluss des ersten Transistors (7) verbunden sind, so dass sich zwischen Emitteranschluss und Kollektoranschluss des zweiten Transistors (11) eine Diodenspannung des Basis-Emitter-Übergangs des zweiten Transistors (11) einstellt.

5. Detektorschaltung (1) nach Anspruch 4, wobei der erste (7) und der zweite Transistor (11) als identische Transistoren ausgebildet sind, wobei der Emitteranschluss des zweiten Transistors (11) über einen Abgriffwiderstand (15) mit dem Anschluss und der Kollektoranschluss des zweiten Transistors (11) über einen weiteren Widerstand (14) mit einem weiteren Versorgungsspannungspotential verbunden sind, wobei das Widerstandsverhältnis zwischen dem Abgriffwiderstand (15) und dem weiteren Widerstand (14) maximal 1:50 beträgt.

6. Detektorschaltung (1) nach Anspruch 5, wobei der erste (7) und der zweite Transistor (11) als Doppeltransistoren in integrierter Form ausgebildet sind.

7. Motorsteuerung zum Ansteuern eines Elektromotors mit einem Ansteuersignal umfassend:
- eine Detektorschaltung (1) nach einem der vorangehenden Ansprüche zum Ausgeben eines Detektionssignals, das eine induktive Spannungsänderung einer Spulenwicklung (2) des Elektromotors angibt,
- eine Kommutatorschaltung (4) zum Kommutieren der Spulenwicklung (2) des Elektromotors abhängig von dem Detektionssignal (DS).

8. Motorsteuerung nach Anspruch 7, wobei mindestens eines der folgenden Elemente vorgesehen ist:
- ein Schmitt-Trigger (9) zum Empfangen des Detektionssignals und zum Filtern von Störungen aus dem Detektionssignal;
- ein Tiefpassfilter (10) zum Filtern von auf dem Detektionssignal auftretenden Störsignalen bei Frequenzen des durch die Kommutatorschaltung erzeugten Ansteuersignals.

9. Elekromotorsystem umfassend:
- eine Motorsteuerung nach Anspruch 7 oder 8,
- ein Elektromotor mit mindestens einer Spulenwicklung (2), wobei die Spulenwicklung mit einem ersten Anschluss (A) fest mit einem Versorgungsspannungspotential verbunden ist, und wobei der Anschluss der Detektorschaltung (1) mit dem zweiten Anschluss der Spulenwicklung (2) verbunden ist, um beim Betrieb des Motors eine in der Spulenwicklung (2) induzierte Spannung zu detektieren.

## Claims

1. Detector circuit (1) for detecting a change in voltage at a connection (A) with respect to a reference potential, comprising:
- an electronic switch (7) having a control connection, which has a predetermined switching potential at which the switch switches, and having a detection signal output for outputting a detection signal (DS),
- a voltage matching circuit which provides a control potential at the control connection of the switch, which control potential corresponds to a potential of the connection (A) which has been changed by a predefined fixed potential magnitude, the predefined fixed potential magnitude being selected in such a manner that the control potential corresponds to the switching potential or corresponds approximately to the switching potential when the reference voltage is applied to the connection (A), such that the change in voltage to be detected causes the switching potential of the electronic switch to be exceeded or undershot,
**characterized in that** the voltage matching circuit has a diode (6) which is directly connected to the connection (A) and to the control connection of the electronic switch (7), the predefined potential magnitude corresponding to the diode voltage or to the breakdown voltage of the diode (6) dropped across the diode (6).

2. Detector circuit (1) according to Claim 1, the electronic switch being in the form of a transistor circuit having a first transistor (7) whose base connection corresponds to the control connection and whose base-emitter voltage is essentially set to the diode voltage of a base-emitter junction of the first transistor (7) when the reference voltage is applied to the connection, such that the first transistor (7) is just still on, the voltage matching circuit being designed in such a manner that the base-emitter voltage falls below the diode voltage when the change in voltage to be detected occurs, with the result that the first transistor (7) changes to the off state.

3. Detector circuit (1) according to Claim 1, the reference voltage corresponding to a supply voltage potential, and the emitter connection of the first transistor (7) being directly connected to the supply voltage potential, with the result that the switching potential is defined as the supply voltage potential which has been changed by the diode voltage of the base-emitter junction.

4. Detector circuit (1) according to either of Claims 2 and 3, the voltage matching circuit comprising a second transistor (11) whose collector connection and base connection are short-circuited and are connected to the base connection of the first transistor (7), with the result that a diode voltage of the base-emitter junction of the second transistor (11) is established between the emitter connection and the collector connection of the second transistor (11).

5. Detector circuit (1) according to Claim 4, the first transistor (7) and the second transistor (11) being in the form of identical transistors, the emitter connection of the second transistor (11) being connected to the connection via a tapping resistor (15), and the collector connection of the second transistor (11) being connected to a further supply voltage potential via a further resistor (14), the resistance ratio of the tapping resistor (15) to the further resistor (14) being at most 1:50.

6. Detector circuit (1) according to Claim 5, the first transistor (7) and the second transistor (11) being in the form of integrated double transistors.

7. Motor controller for driving an electric motor with a drive signal, comprising:
- a detector circuit (1) according to one of the preceding claims for outputting a detection signal which indicates an inductive change in the voltage of a coil winding (2) of the electric motor,
- a commutator circuit (4) for commutating the coil winding (2) of the electric motor on the basis of the detection signal (DS).

8. Motor controller according to Claim 7, at least one of the following elements being provided:
- a Schmitt trigger (9) for receiving the detection signal and for filtering interference from the detection signal;
- a low-pass filter (10) for filtering interference signals which occur in the detection signal at frequencies of the drive signal generated by the commutator circuit.

9. Electric motor system comprising:
- a motor controller according to Claim 7 or 8,
- an electric motor having at least one coil winding (2), a first connection (A) of the coil winding being permanently connected to a supply voltage potential, and the connection of the detector circuit (1) being connected to the second connection of the coil winding (2) in order to detect a voltage induced in the coil winding (2) during operation of the motor.

## Revendications

1. Circuit détecteur (1) pour détecter une variation de tension sur une borne (A) par rapport à un potentiel de référence, comprenant :
- un commutateur électronique (7) muni d'une borne de commande qui présente un potentiel de commutation prédéfini auquel commute le commutateur et muni d'une borne de sortie de signal de détection pour délivrer un signal de détection (DS),
- un circuit d'adaptation de tension qui fournit un potentiel de commande à la borne de commande du commutateur, lequel correspond à un potentiel de la borne (A) modifié d'une valeur de potentiel fixe prédéfinie, la valeur de potentiel fixe prédéfinie étant sélectionnée de telle sorte que le potentiel de commande soit égal ou corresponde approximativement au potentiel de commutation lors de l'application de la tension de référence à la borne (A), de sorte que la variation de tension à détecter provoque un franchissement vers le haut ou vers le bas du potentiel de commutation du commutateur électronique,
**caractérisé en ce que** le circuit d'adaptation de tension est formé avec une diode (6) qui est reliée directement avec la borne (A) et avec la borne de commande du commutateur électronique (7), la valeur de potentiel prédéfinie correspondant à la tension de diode ou à la tension de claquage de la diode (6) qui chute aux bornes de la diode (6).

2. Circuit détecteur (1) selon la revendication 1, le commutateur électronique étant réalisé sous la forme d'un circuit à transistor avec un premier transistor (7) dont la borne de base correspond à la borne de commande et dont la tension base-émetteur, lors de l'application de la tension de référence à la borne, est pour l'essentiel réglée à la tension de diode d'une transition base-émetteur du premier transistor (7), de sorte que le premier transistor (7) est encore à peine passant, le circuit d'adaptation de tension étant configuré de telle sorte que la tension base-émetteur chute au-dessous de la tension de diode lorsque la variation de tension à détecter se produit, ce qui a pour effet que le premier transistor (7) passe à l'état bloqué.

3. Circuit détecteur (1) selon la revendication 1, la tension de référence correspondant à un potentiel de tension d'alimentation et la borne d'émetteur du premier transistor (7) étant reliée directement au potentiel de tension d'alimentation de sorte que le potentiel de commutation soit fixé comme étant le potentiel de tension d'alimentation modifié de la tension de diode de la transition base-émetteur.

4. Circuit détecteur (1) selon l'une des revendications 2 et 3, le circuit d'adaptation de tension comprenant un deuxième transistor (11) dont la borne de collecteur et la borne de base sont en court-circuit et sont reliées avec la borne de base du premier transistor (7) de sorte qu'une tension de diode de la transition base-émetteur du deuxième transistor (11) s'établit entre la borne d'émetteur et la borne de collecteur du deuxième transistor (11).

5. Circuit détecteur (1) selon la revendication 4, le premier (7) et le deuxième transistor (11) étant réalisés sous la forme de transistors identiques, la borne d'émetteur du deuxième transistor (11) étant reliée par le biais d'une résistance de prélèvement (15) avec la borne et la borne de collecteur du deuxième transistor (11) étant reliée par le biais d'une autre résistance (14) avec un autre potentiel de tension d'alimentation, le rapport entre la résistance de prélèvement (15) et l'autre résistance (14) étant au maximum de 1:50.

6. Circuit détecteur (1) selon la revendication 5, le premier (7) et le deuxième transistor (11) étant réalisés sous la forme de doubles transistors sous forme intégrée.

7. Commande de moteur pour commander un moteur électrique avec un signal de commande comprenant :
- un circuit détecteur (1) selon l'une des revendications précédentes pour délivrer un signal de détection qui indique une variation de tension inductive d'un enroulement de bobine (2) du moteur électrique,
- un circuit commutateur (4) pour commuter l'enroulement de bobine (2) du moteur électrique en fonction du signal de détection (DS).

8. Commande de moteur selon la revendication 7, au moins l'un des éléments suivants étant préau :
- un trigger de Schmitt (9) pour recevoir le signal de détection et pour éliminer par filtrage les perturbations du signal de détection ;
- un filtre passe-bas (10) pour filtrer les signaux parasites qui se produisent sur le signal de détection aux fréquences du signal de commande généré par le circuit commutateur.

9. Système à moteur électrique comprenant :
- une commande de moteur selon la revendication 7 ou 8,
- un moteur électrique comprenant au moins un enroulement de bobine (2), l'enroulement de bobine étant relié en permanence avec un potentiel de tension d'alimentation par une première borne (A) et la borne du circuit détecteur (1) étant reliée avec la deuxième borne de l'enroulement de bobine (2) afin de détecter une tension induite dans l'enroulement de bobine (2) lors du fonctionnement du moteur.
